# EUROPEAN PATENT SPECIFICATION

(11) **EP 0 346 089 B1**
(45) Date of publication and mention of the grant of the patent: **29.09.1993**
(21) Application number: 89305733.1
(22) Date of filing: 07.06.1989
(51) Int. Cl.: H01Q 1/12

(54) **Reception system**
Empfangssystem
Système de réception

(30) Priority: 10.06.1988 JP 77189/88; 10.06.1988 JP 77190/88
(43) Date of publication of application: 13.12.1989
(73) Proprietor: NIPPON SHEET GLASS CO., LTD., Chuo-ku Osaka (JP)
(72) Inventor: Sakurai, Kaoru c/o Nippon Sheet Glass Co., Ltd., Chuo-ku Osaka (JP); Murakami, Harunori Nippon Sheet Glass Co., Ltd., Chuo-ku Osaka (JP); Iijima, Hiroshi Nippon Sheet Glass Co., Ltd., Chuo-ku Osaka (JP); Maeda, Masaru Nippon Sheet Glass Co., Ltd., Chuo-ku Osaka (JP); Matsuda, Koji Nippon Sheet Glass Co., Ltd., Chuo-ku Osaka (JP)
(74) Representative: Jackson, David Spence

(56) References cited:
- EP-A- 0 146 339
- EP-A- 0 269 924
- DE-A- 3 409 876
- GB-A- 2 187 042
- RADIOELECTRONICS AND COMMUNICATIONS SYSTEMS, vol. 28, no. 12, 1985, pages 77-79, Allerton Press, Inc., New York, NY, US; V.A. GLUKHOV: "Design of an equalizing network"
- THE ARRL ANTENNA BOOK, 14th edition, 1983, pages 4/1 - 4/11, chapter 4: "Coupling the transmitter to the line"

## Description

### BACKGROUND OF THE INVENTION

### Field of the Invention:

The present invention relates to a reception system for a motor vehicle and, more particularly, to a system using an antenna circuit having a large ground stray capacitance.

### Description of the Prior Art:

A defogging heater conductor is attached to a window glass, particularly to a rear window glass of a vehicle by baking or embedding. As is well known, the heater conductor is used as an antenna or a portion of an antenna element for an AM broadcast band.

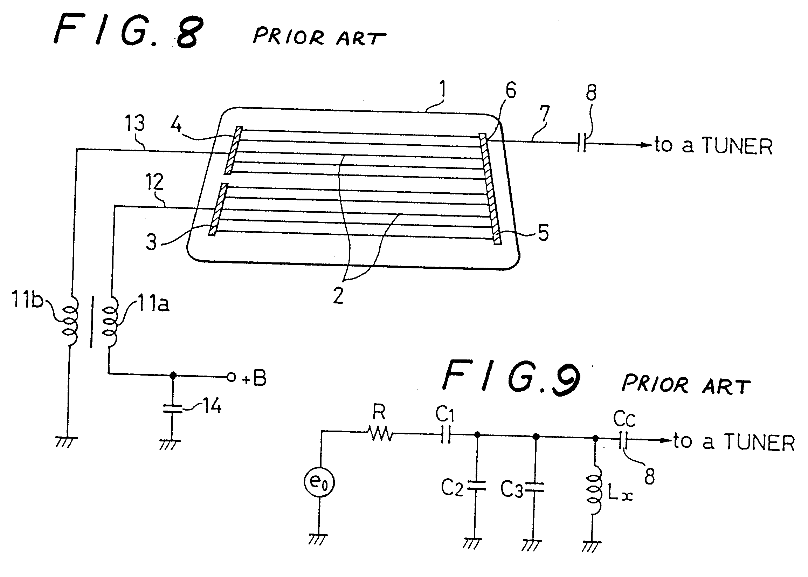

Fig. 8 is a view showing a conductor pattern of a window glass antenna of this type. A large number of heater wires 2 are attached to a defogging region of a rear window glass 1, and power is fed through feeder buses 3 and 4 connected to one end of upper and lower groups of the heater wires and is returned through a junction bus 5 connected to the other end thereof. When the heater wires 2 are used as an AM broadcast reception antenna, a feeder 7 such as a coaxial cable is connected to a feed point 6 of the junction bus 5, and a reception signal is output to a tuner through a DC cut capacitor 8.

Heating currents flow in feeder buses 3 and 4 through magnetically coupled choke coils 11a and 11b and feeders 12 and 13, respectively. The choke coil 11a connected to a main power supply +B and the choke coil 11b connected to the ground point are negatively coupled, so that magnetic flux due to the corresponding heating currents cancel each other in the cores, and small-volume cores can be used for operation in a nonsaturated state. For a received high frequency wave, the choke coils 11a and 11b exhibit high impedances. Since a reception signal induced in the heater wires 2 is prevented from leaking to a low-impedance power supply or ground, reception efficiency is improved. Note that a line connected to the main power supply +B is connected to a decoupling capacitor 14, so that power supply noise is not mixed in the reception signal.

Fig. 9 is an equivalent circuit diagram of the antenna shown in Fig. 8. Reference symbol e0 denotes an induction electromotive force of the heater wires 2; C1, an active capacitance of the antenna; C2, a reactive capacitance of the antenna; C3, a stray capacitance (reactive capacitance) of the feeders 12 and 13, the feeder cable 7, and the like; Cc, a capacitance of the capacitor 8; R, an internal resistance of the antenna; and Lx, an inductance of the heater wire 2 and the choke coils 11a and 11b.

When an AM broadcast signal is received by the heater wires 2, the magnitude of the induction electromotive force e0 depends on the size of the rear window glass 1. When the window glass area is small, the induction electromotive force e0 is small.

However, the reactive capacitances C2 and C3 in the equivalent circuit diagram shown in Fig. 9 are not decreased in proportion as the window glass area is decreased. For this reason, when the window glass area is small, a signal loss due to the reactive capacitances C2 and C3 is relatively increased. Accordingly, when a glass antenna with a small reception area is used, an AM broadcast signal cannot be received well.

Two additional examples of such a reception system, using a motor vehicle window defogging heater and including an antenna element for supplying a reception signal to a receiver via a matching circuit, are disclosed in published European patent applications EP-A-0269924 (Harada) and EP-A-0146339 (BSH). In the Harada system, separate compensation circuits are provided for AM and FM signals, with respective air-core type band-pass filter coils being provided between the battery and heating wires. In the BSH system, various configurations of matching circuit based on choke coils in the heater element current supply lines are disclosed providing series or parallel resonance, or resonance in two pass-bands, near the centre of the VHF band.

### SUMMARY OF THE INVENTION

It is a primary object of the invention to compensate for a reduction in gain due to reactive capacitances and to improve a reception sensitivity over a wide range.

In accordance with the present invention there is provided a reception system for a motor vehicle having an antenna circuit including an antenna element for supplying a reception signal to a receiver via a matching circuit, characterized in that said matching circuit comprises first and third coils connecting the antenna circuit to ground and constituting a first parallel resonant circuit together with a ground stray capacitance thereof at a frequency set in a reception band, said first coil being series-connected to said third coil and said third coil including a core member having its permeability being set to decrease between lower and higher ends of said reception band with increase of frequency so that the resonance frequency of said parallel resonance circuit increases as a reception frequency increases; and matching means including a second coil associated with said parallel resonant circuit to compensate for a Q-factor thereof so that reception gain is improved over a wide range of reception frequencies.

An impedance of the antenna circuit is increased in a reception band by parallel resonance, and a signal loss due to the ground stray capacitance can be reduced. The matching means compensates for Q-factor of the parallel resonance circuit increasing too much and makes the antenna circuit match with the receiver. Reception sensitivity is improved over a wide range in a reception band.

### BRIEF DESCRIPTION OF THE DRAWINGS

These and other objects, features, and advantages of the invention will become more apparent upon a reading of the following detailed specification and drawings in which:
Fig. 1 is a diagram of a rear window glass antenna for a vehicle to which an embodiment of the present invention is applied;
Fig. 2 is a circuit diagram of a matching circuit in Fig. 1;
Fig. 3 is a circuit diagram of a single parallel resonance circuit found in the prior art;
Fig. 4 is a graph showing reception sensitivity-frequency characteristics when the parallel resonance circuit shown in Fig. 3 is used;
Fig. 5 is a graph showing inductance-frequency characteristics of a coil used in the embodiment shown in Fig. 2;
Fig. 6 is a graph showing reception sensitivity-frequency characteristics obtained when the matching circuit shown in Fig. 2 is used;
Fig. 7 is a circuit diagram of a modification of the matching circuit which is inserted after a feeder cable;
Fig. 8 is a diagram of a conventional window glass antenna; and
Fig. 9 is an equivalent circuit diagram of Fig. 8.

### DETAILED DESCRIPTION OF THE PREFERRED EMBODIMENTS

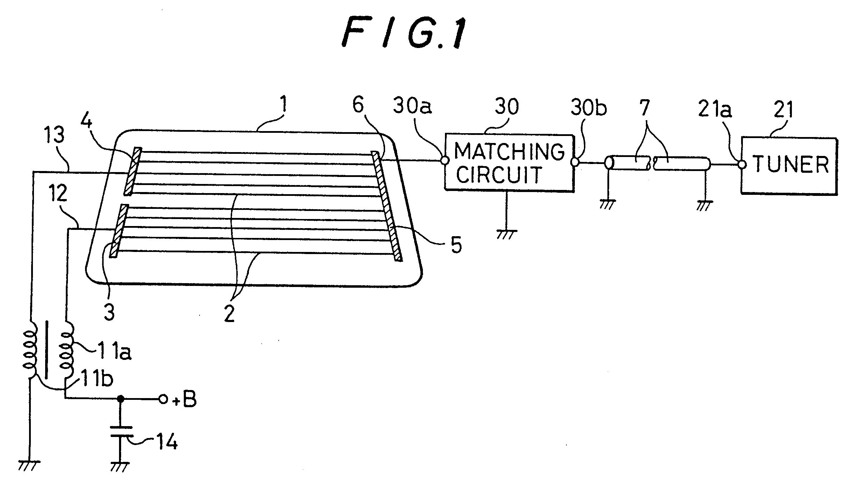

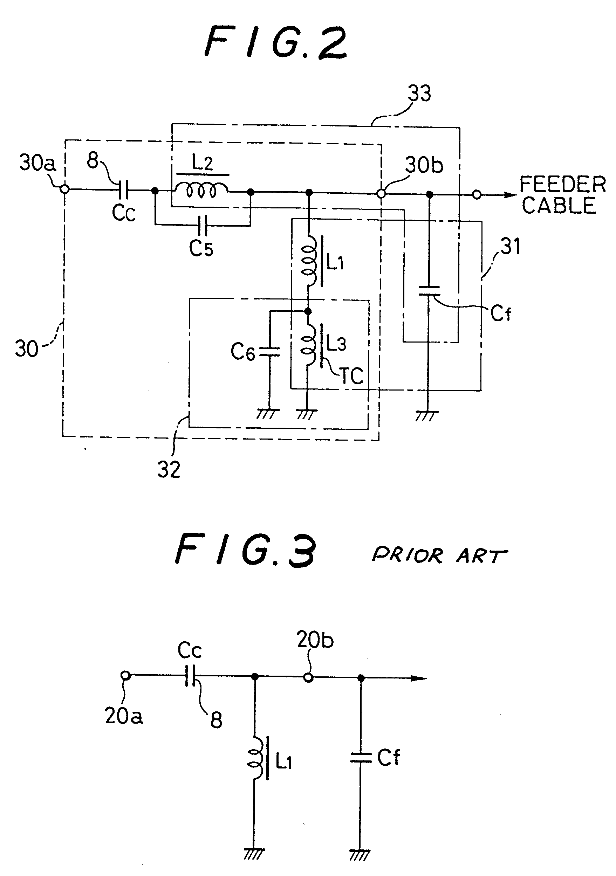

Fig. 1 is a diagram of a rear window glass antenna for a vehicle according to an embodiment of the invention. Fig. 2 is a circuit diagram of a matching circuit in Fig. 1. The conductor pattern of the rear window glass 1 and a supply circuit of heating currents are the same as those in Fig. 8. In this embodiment, a reception signal of heater wires 2 derived from a feed point 6 is supplied to a matching circuit 30, and an output from the matching circuit 30 is supplied to an input terminal 21a of a tuner 21 through a 3- to 4-m long feeder cable 7.

As shown in Fig. 2, a capacitor Cc and a coil L2 are connected in series with input and output terminals 30a and 30b of the matching circuit 30. The output side of the coil L2 is grounded through a series circuit of coils L1 and L3.

The capacitor Cc is a coupling capacitor (having a capacitance of, e.g., 1,000 pF) for extracting reception power induced in the heater wires 2. A reception signal whose DC component is cut by the capacitor Cc is input to the coil L1. The coil L2 is provided to improve reception sensitivity in a high-frequency range of the AM broadcast band. The coil L2 and a reactive capacitance Cf constitute a low-pass filter to be described later. The reactive capacitance Cf between the output terminal 30b and ground represents a ground stray capacitance of the feeder cable 7. A capacitor C5 connected in parallel with the coil L2 is a bypass capacitor (having a capacitance of, e.g., 68 pF) for allowing a reception signal in the FM broadcast band to pass with a small loss, and is connected when the heater wires 2 (antenna) are used for both AM and FM broadcast signals.

The series circuit of the coils L1 and L3 and the reactive capacitance Cf constitute a first parallel resonance circuit 31. When the parallel resonance circuit 31 is parallel-resonated, a reactive component can be cancelled to improve power reception efficiency. When a 4-m long feeder cable 7 having a distributed capacitance of 30 pF/m is used, the reactive capacitance Cf is about 120 pF. In this case, the inductance of the coil L2 is 180 µH, and the inductance of the coil L3 is 140 µH as a nominal value. The inductance of the coil L3 has frequency characteristics, as will be described later.

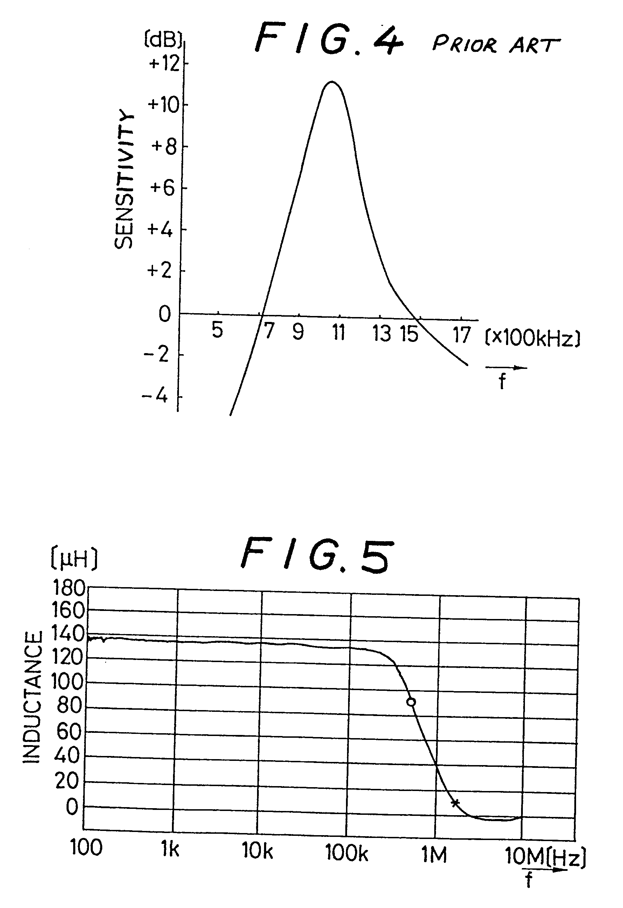

As shown in a prior art circuit diagram of Fig. 3, when only the coil L1 of the fixed inductance is connected in parallel with the reactive capacitance Cf, the reception band becomes very narrow, and sensitive in a range of 800 to 1,300 kHz, as shown in the frequency characteristic graph of reception sensitivity in Fig. 4.

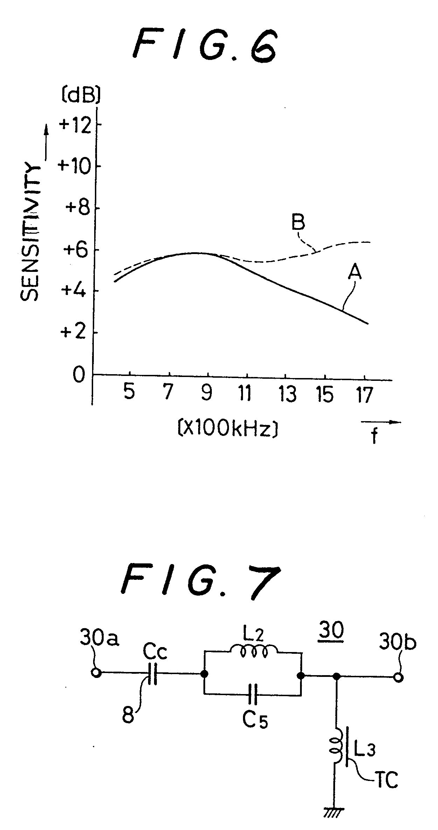

In order to obtain wide-range reception characteristics, the coil L3 connected in series with the coil L1 is provided with inductance-frequency characteristics shown in Fig. 5. More specifically, in a low frequency range up to 200 kHz, the inductance is substantially constant, i.e., about 140 µH, and in a frequency range higher than 200 kHz, the inductance is steeply decreased as the frequency is increased. In an AM reception band between points o and x, the inductance is 95 µH at 500 kHz, and is 10 µH at 1,500 kHz.

The coil L3 is formed by winding a wire having a diameter of 0.4 mm seven turns around a toroidal core TC having a high permeability (µ = 5,000).

Therefore, a total inductance L1 + L3 of the first parallel resonance circuit 31 is decreased from 275 µH to 190 µH in a reception band from 500 kHz to 1,500 kHz. For this reason, a resonant point of the first parallel resonance circuit 31 is shifted toward a high-frequency range along with an increase in frequency of a reception signal. Therefore, the first resonance circuit 31 can have wider-range frequency characteristics.

Furthermore, in order to improve reception sensitivity in a low-frequency range, a capacitor C6 is connected in parallel with the coil L3 to constitute a second resonance circuit 32. The capacitance of the capacitor C6 is adjusted in correspondence with the reactive capacitance Cf, and the second parallel resonance circuit 32 is resonated near 800 kHz in a low-frequency range. The capacitance of the capacitor C6 is set to be about 280 pF when the reactive capacitance Cf = 120 pF.

As described above, the first parallel resonance circuit 31 is parallel-resonated in middle- and high-frequency ranges of the reception band, and the second parallel resonance circuit 32 is parallel-resonated in a low-frequency range of the reception band. As a result, as indicated by a characteristic curve A of the reception sensitivity graph of Fig. 6, good reception performance can be obtained over a very wide range. The characteristics A are obtained when a series coil L2 to be described below is omitted.

In order to further improve reception sensitivity in a high-frequency range, the coil L2 for forming the low-pass filter 33 together with the reactive capacitance Cf is arranged. If the inductance of the coil L2 is about 47 µH, it causes a kind of resonance at about 2 MHz with the reactive capacitance Cf of 120 pF. As indicated by a characteristic curve B indicated by a broken curve B in Fig. 6, sensitivity in middle- and high-frequency ranges of the reception band is improved.

The matching circuit 30 in Fig. 1 is inserted at an end of the feeder cable 7 on the side of window glass 1. The matching circuit 30 may be inserted at another end of the feeder cable 7 on the side of the tuner 21. Antenna and the matching circuit 30 are coupled through the feeder cable 7. In this arrangement, the reactive capacitance may consist of a stray capacitance to ground for the glass antenna comprising the heater wires 2 and a stray capacitance to ground for the cable 7, both coupled in parallel.

The matching circuit 30 may be incorporated in the tuner 21. The capacitor C5 for bypassing an FM reception signal can be omitted when the matching circuit 30 is arranged in an AM tuner.

Fig. 7 is a modification of the matching circuit 30 in which the coil L1 is removed by preferably adjusting the inductance value of coil L3 and permeability of a toroidal core for the coil L3. A similar function as that for Fig. 2 is effective for this arrangement. For example, a core material having permeability µ as large as 2,500 to 8,000 may be applied to the coil L3 in the case where a 3- to 4-m long feeder cable 7 having a reactive capacitance Cf of about 120 pF is used. The coil L3 is wound on the core to have an inductance of 850 µH at 500 kHz and 75 µH at 1,700 kHz. A series coil L2 and a capacitor C5 in parallel therewith may be provided if required.

According to the embodiment as described above, a resonance coil whose inductance is decreased along with an increase in reception frequency is arranged in parallel with a ground stray capacitance valued at an input terminal of a tuner on an antenna side, and is parallel-resonated in a reception band. For this reason, if a constant inductance which is parallel-resonated with the reactive capacitance is merely employed, Q is too high and a band is narrow. However, when the inductance is provided with frequency characteristics in a reception band, the resonance frequency changes in correspondence with a reception frequency, and a reduction in gain due to ground stray capacitance can be compensated for over a wide range. Therefore, reception sensitivity of an antenna circuit having a large reactive capacitance can be improved over the entire reception band.

## Claims

1. A reception system for a motor vehicle having an antenna circuit including an antenna element (2) for supplying a reception signal to a receiver (21) via a matching circuit (30), characterized in that said matching circuit comprises:
first and third coils (L1, L3) connecting the antenna circuit (2, 6, 7, 8) to ground and constituting a first parallel resonant circuit (31) together with a ground stray capacitance (Cf) thereof at a frequency set in a reception band,
said first coil (L1) being series-connected to said third coil (L3) and
said third coil (L3) including a core member (TC) having its permeability being set to decrease between lower and higher ends of said reception band with increase of frequency so that the resonance frequency of said parallel resonance circuit increases as a reception frequency increases; and
matching means including a second coil (L2) associated with said parallel resonant circuit to compensate for a Q-factor thereof so that reception gain is improved over a wide range of reception frequencies.

2. A reception system according to claim 1, wherein said parallel resonant circuit (31) and said matching means operate effectively in an AM broadcast band and a capacitor (C5) is parallel connected to said second coil (L2) for FM reception signal to bypass the coil.

3. A reception system according to claim 1, wherein said antenna circuit comprises a feeder cable (7) connected between said antenna element (2) and said receiver (21), said first coil (L1) being connected to said feeder cable (7) on the side of said antenna element (2), said second coil (L2) connecting said antenna element (2) to said feeder cable (7) and said ground stray capacitance (C_{f}) being that of said feeder cable.

4. A reception system according to claim 1, wherein said parallel resonant circuit (31) includes a capacitor (C₆) paralleled to said third coil (L3), so as to be set to resonate at the frequency on the lower side of the reception band.

## Patentansprüche

1. Empfangssystem für ein Kraftfahrzeug, mit einer Antennenschaltung, die ein Antennenelement (2) zur Lieferung eines Empfangssignals an einen Empfänger (21) über eine Anpassungsschaltung (30) aufweist, **dadurch gekennzeichnet**, daß die Anpassungsschaltung folgendes enthält:
- erste und dritte Spulen (L1, L3),die die Antennenschaltung (2,6,7,8) mit Erde verbinden und zusammen mit deren Streukapazität (Cf) gegen Erde eine erste Parallelresonanzschaltung (31) bei einer in einem Empfangsband eingestellten Frequenz bilden, wobei
- die erste Spule (L1) in Serie zu der dritten Spule (L3) geschaltet ist,
- die dritte Spule (L3) ein Kernelement (TC) aufweist, dessen Permeabilität zwischen unteren und oberen Enden des Empfangsbandes mit ansteigender Frequenz abnimmt, so daß die Resonanzfrequenz der Parallelresonanzschaltung mit steigender Empfangsfrequenz ebenfalls ansteigt, und
- die Anpassungsschaltung ferner eine zweite Spule (L2) aufweist, die mit der Parallelresonanzschaltung zusammenarbeitet, um deren Q -Faktor zu kompensieren, so daß sich ein verbesserter Empfangsgewinn über einen weiten Bereich von Empfangsfrequenzen ergibt.

2. Empfangssystem nach Anspruch 1, **dadurch gekennzeichnet**, daß die Parallelresonanzschaltung (31) und die Anpassungsschaltung im AM Rundfunkband arbeiten und ein Kondensator (C5) zur zweiten Spule (L2) parallel geschaltet ist, um ein FM Empfangssignal an dieser vorbeizuleiten.

3. Empfangssystem nach Anspruch 1, **dadurch gekennzeichnet**, daß die Antennenschaltung ein Speisekabel (7) aufweist, das zwischen dem Antennenelement (2) und dem Empfänger (21) verläuft, wobei die erste Spule (L1) mit dem Speisekabel (7) an der Seite des Antennenelements (2) verbunden ist, die zweite Spule (L2) das Antennenelement (2) mit dem Speisekabel (7) verbindet und die Streukapazität (Cf) gegen Erde diejenige des Speisekabels ist.

4. Empfangssystem nach Anspruch 1, **dadurch gekennzeichnet**, daß die Parallelresonanzschaltung (31) einen parallel zur dritten Spule (L3) liegenden Kondensator (C6) aufweist, um eine Resonanz bei einer Frequenz an der unteren Seite des Empfangsbandes zu zeigen.

## Revendications

1. Système de réception pour un véhicule à moteur comportant un circuit d'antenne incluant un élément d'antenne (2) pour appliquer un signal de réception à un récepteur (21) via un circuit d'adaptation (30), caractérisé en ce que ledit circuit d'adaptation comprend :
des première et troisième bobines (L1, L3) qui connectent le circuit d'antenne (2, 6, 7, 8) à la masse et qui constituent un premier circuit résonant parallèle (31) en association avec une capacité parasite de masse (Cf) de celles-ci à une fréquence établie dans une bande de réception ;
ladite première bobine (L1) étant connectée en série à ladite troisième bobine (L3) ; et
ladite troisième bobine (L3) incluant un élément de noyau (TC) dont la perméabilité est établie de manière à diminuer entre les extrémités inférieure et supérieure de ladite bande de réception lorsque la fréquence augmente de telle sorte que la fréquence de résonance dudit circuit de résonance parallèle augmente lorsque la fréquence de réception augmente ; et
un moyen d'adaptation incluant une seconde bobine (L2) associée audit circuit résonant parallèle pour compenser son facteur Q de telle sorte qu'un gain de réception soit amélioré sur une large plage des fréquences de réception.

2. Système de réception selon la revendication 1, dans lequel ledit circuit résonant parallèle (31) et ledit moyen d'adaptation fonctionnent de manière efficiente dans une bande de diffusion en modulation d' amplitude (AM) et une capacité (C5) est connectée en parallèle à ladite seconde bobine (L2) pour un signal de réception en modulation de fréquence (FM), en dérivant la bobine.

3. Système de réception selon la revendication 1, dans lequel ledit circuit d'antenne comprend un câble d'alimentation (7) connecté entre ledit élément d'antenne (2) et ledit récepteur (21), ladite première bobine (L1) étant connectée audit câble d'alimentation (7) sur le côté dudit élément d'antenne (2), ladite seconde bobine (L2) connectant ledit élément d'antenne (2) audit câble d'alimentation (7) et ladite capacité parasite de masse (Cf) étant celle dudit câble d'alimentation.

4. Système de réception selon la revendication 1, dans lequel ledit circuit résonant parallèle (31) inclut une capacité (C₆) connectée en parallèle à ladite troisième bobine (L3) de manière à être amenée à résonner à la fréquence située sur le côté inférieur de la bande de réception.
